# EUROPÄISCHE PATENTANMELDUNG

(11) **EP 4 477 618 A1**
(43) Veröffentlichungstag der Anmeldung: **18.12.2024**
(21) Anmeldenummer: 23179193.0
(22) Anmeldetag: 14.06.2023
(51) Int. Cl.: C01B 32/186, C23C 16/26, B32B 37/26

(54) **BESCHICHTETES METALLBLECH ZUR HERSTELLUNG VON GRAPHEN**

(71) Anmelder: voestalpine Stahl GmbH, 4020 Linz (AT)
(72) Erfinder: Stellnberger, Karl-Heinz, 4020 Linz (AT)
(74) Vertreter: Wildhack & Jellinek Patentanwälte GmbH

(57) **Zusammenfassung**

Die Erfindung betrifft ein Verfahren zur Herstellung von Graphen (3), wobei ein Trägermaterial bereitgestellt wird, wobei auf dem Trägermaterial Graphen (3) durch chemische Gasphasenabscheidung hergestellt wird, wobei das Graphen (3), insbesondere durch einen Bubble-Transferprozess, vom Trägermaterial abgelöst und zur Lagerung auf eine Lagerfolie (4) übertragen wird. Erfindungsgemäß ist vorgesehen, dass als Trägermaterial ein kupferbeschichtetes (2) Metallblech (1) bereitgestellt wird. Die Erfindung bezieht sich weiters auf Graphen (3), hergestellt nach diesem Verfahren und auf ein kupferbeschichtetes Metallblech zur Verwendung in diesem Verfahren.

## Beschreibung

Die Erfindung betrifft ein Verfahren zur Herstellung von Graphen, Graphen hergestellt in diesem Verfahren und ein kupferbeschichtetes Metallblech zur Herstellung von Graphen.

Graphen ist ein Allotrop des Kohlenstoffs, das aus einer einzigen Schicht von Atomen besteht, die in einer hexagonalen Gitterstruktur angeordnet sind. Es wird aufgrund seiner Materialeigenschaften für viele Anwendungsbereiche vorgeschlagen. Der praktische Einsatz von Graphen ist derzeit jedoch aufgrund der hohen Herstellungskosten sehr beschränkt. Für die Herstellung von Graphen gibt es verschiedene Methoden:
Ursprünglich wurde Graphen durch Exfolierung mechanisch aus Graphit gewonnen. Nachteilig an dieser Methode ist, dass nur kleine Flächen gewonnen werden können, wobei zudem ein hoher Anteil an Graphenoxid enthalten ist.

Die Herstellung größerer Flächen mit besserer Qualität ist durch chemische Gasabscheidung (CVD) möglich. Die Herstellung von Graphen durch CVD ist beispielsweise in P. Trinsoutrot et al., Surface and Coatings Technology, 2013, 230, 87-92 beschrieben. Aus US 2011/195207 A1 ist eine Vorrichtung zur kontinuierlichen Graphen-Herstellung durch CVD bekannt.

Ein solches Verfahren zur Herstellung von Graphen wurde beispielsweise auch in WO 2013 154997 A1 beschrieben. Dabei wird Graphen durch CVD auf einer Kupferfolie abgeschieden. Anschließend wurde die Kupferfolie aufgelöst und das Graphen auf eine Folie aus Titanium übertragen. Nachteilig an diesem Verfahren ist einerseits, dass die Struktur des Graphen durch die unterschiedliche Abkühlung von Kupfer und Graphen teilweise gestört wird, so dass die Qualität des Graphen gering ist. Zudem ist die Produktion sehr aufwendig und teuer, insbesondere auch aufgrund des hohen Verbrauchs an Kupfer.

Ein Verfahren, das diese Nachteile teilweise überwindet, wurde in DE 10 2013 220 158 A1 beschrieben. Dabei wird zunächst ebenfalls ein Kupferband bereitgestellt. Auf diesem Kupferband wird Graphen durch CVD abgeschieden. Anschließend wird das heiße Graphen zum Abkühlen auf ein Transferband übertragen und das Kupferband wird durch einen Bubble-Transferprozess abgelöst. Das Bubble-Transferverfahren ist beispielsweise in L. Eao et al., Nature Communications, DOI: 10.1038/NCOMMS1702 beschrieben. Nach dem Abkühlen wird das Graphen vom Transferband zur Lagerung auf eine weitere Folie übertragen. Auf diese Weise kann Graphen in höherer Qualität hergestellt werden. In DE 10 2013 220 158 ist weiters beschrieben, dass das Kupferband und das Transferband wiederverwendet werden können. Durch das mehrmalige Umlagern kommt es jedoch auch bei diesem Verfahren zu Beschädigungen des Graphen. Ein weiterer Nachteil besteht darin, dass das Kupferband nur eine geringe Reißfestigkeit aufweist, sodass die Wiederverwendung schwierig ist und der Prozess nur mit einer geringen Bandgeschwindigkeit laufen kann.

Die Produktionsgeschwindigkeit von Graphen ist derzeit mit 0,12 m / min extrem langsam. Graphen - Folien, insbesondere großflächige Folien von hoher Qualität, sind daher sehr teuer.

Aufgabe der Erfindung ist es daher eine raschere und kostengünstigere Produktion von Graphen zu ermöglichen.

Diese Aufgabe wird bei einem Verfahren zur Herstellung von Graphen, wobei ein Trägermaterial bereitgestellt wird, wobei auf dem Trägermaterial Graphen durch chemische Gasphasenabscheidung hergestellt wird, wobei das Graphen, insbesondere durch einen Bubble-Transferprozess, vom Trägermaterial abgelöst und zur Lagerung auf eine Lagerfolie übertragen wird, dadurch gelöst, dass als Trägermaterial ein kupferbeschichtetes Metallblech bereitgestellt wird.

Das Metallblech weist eine höhere Reißfestigkeit auf, sodass der Prozess mit höherer Geschwindigkeit durchgeführt werden kann und das Trägermaterial häufiger wiederverwendet werden kann. Dadurch kommt es zu einer deutlichen Kostenersparnis. Kupferbeschichtet im Sinne der Erfindung bedeutet, dass der Anteil des Kupfers in der Kupferschicht mindestens 90 Gew.-% beträgt, bevorzugt mindestens 99 Gew.-%, wobei der Rest allfällige Verunreinigungen darstellt.

Um das Graphen mit besonders hoher Qualität herzustellen, kann das bereitgestellte Metallblech aus einer Legierung mit einem Wärmeausdehnungskoeffizienten im Bereich von 20 - 400°C unter 20 [10^-6 m/(m x K)], insbesondere unter 15 [10^-6 m/(m x K)], vorzugsweise unter 12 [10^-6 m/(m x K)], bestehen. Durch den niedrigen Wärmeausdehnungskoeffizienten können Beschädigungen der Struktur des Graphens beim Abkühlen des Graphens auf dem Trägermaterial vermieden werden.

Besonders geeignet ist ein Verfahren, bei dem das bereitgestellte Metallblech aus einer Stahllegierung oder einer Aluminiumlegierung besteht.

Um das Verfahren besonders kostengünstig führen zu können, kann das bereitgestellte Metallblech eine Legierung mit der folgenden Zusammensetzung enthalten (in Gew%):

| | |
|---|---|
| 0,01 bis 0,20 | Kohlenstoff (C), |
| 30 bis 40 | Nickel (Ni) |
| 0,01 bis 0,60 | Mangan (Mn), |
| 0,01 bis 0,40 | Silizium (Si), |
| < 0,06 | Phosphor (P), |
| < 0,04 | Schwefel (S), |

optional enthaltend:

| | |
|---|---|
| 0 bis 0,25 | Chrom (Cr), |
| 0 bis 0,50 | Kobalt (Co) |
| 0 bis 0,20 | Aluminium (Al), |
| 0 bis 0,50 | Molybdän (Mo) |
| 0 bis 0,50 | Kupfer (Cu) |
| 0 bis 0,30 | Vanadium (V) |
| 0 bis 0,20 | Titan (Ti) |
| 0 bis 0,20 | Niob (Nb) |
| 0 bis 0,005 | Bor (B) |
| 0 bis 0,015 | Stickstoff (N) |
| 0 bis 0,01 | Kalzium (Ca) |

sowie als Rest Eisen (Fe) und herstellungsbedingt unvermeidbare Verunreinigungen.

Diese Legierung wird für verschiedenste Anwendungsbereiche verwendet und in größeren Mengen hergestellt, sodass die Produktionskosten für das Metallblech niedrig gehalten werden können. Für das erfindungsgemäße Verfahren ist diese Legierung zudem besonders gut geeignet, da bei der Beschichtung mit Kupfer eine sehr gleichmäßige Kupferschicht erzeugt werden kann. Dies ermöglicht die Herstellung von Graphen mit besonders hoher Qualität.

Insbesondere der Stahlwerkstoff 1.3912 ist hierbei besonders geeignet, da er einen besonders niedrigen Ausdehnungskoeffizienten aufweist. Auch der Stahlwerkstoff 1.4412 ist gut geeignet.

Besonders hochwertiges Graphen kann hergestellt werden, wenn das bereitgestellte Trägermaterial eine Kupferschicht in 111-Ausrichtung aufweist. Dadurch können Strukturunregelmäßigkeiten im Graphen vermieden werden.

Für die Herstellung von qualitativ besonders hochwertigem Graphen ist ein Verfahren besonders geeignet, wobei das Trägermaterial hergestellt wird, indem die Kupferschicht auf dem Metallblech durch Gasphasenabscheidung, insbesondere physikalische Gasphasenabscheidung, aufgebracht wird. Auf diese Weise kann eine genau definierte Kupferschicht mit gleichmäßiger Schichtdicke und besonders regelmäßige Ausrichtung bereitgestellt werden. So ist durch Gasphasenabscheidung eine Kupferschicht mit 111-Ausrichtung erhältlich. Gleichzeitig kann durch Gasphasenabscheidung das Metallblech zur Herstellung des Trägermaterials mit einer hohen Geschwindigkeit von 10 bis 180 m / min. mit Kupfer beschichtet werden.

Das Verfahren zur Herstellung von Graphen ist besonders ressourcenschonend und kostengünstig, wenn das Trägermaterial nach dem Ablösen des Graphens wieder für die Herstellung von Graphen bereitgestellt wird. Auf diese Weise ist ein Prozesskreislauf möglich, indem das Trägermaterial direkt wiederverwendet werden kann. Wenn es nach zahlreichen Durchläufen doch zu einer Beschädigung der Kupferbeschichtung kommt, so kann zudem das Kupfer vom Metallblech abgebeizt werden. Das gesammelte Kupfer kann wieder zum Beschichten eines Metallblechs verwendet werden, beispielsweise im PVD-Plasmaverfahren. Ebenso kann das gereinigte Metallblech wieder mit Kupfer beschichtet werden. Zum Reinigen des Metallblechs ist beispielsweise ein Plasmaätzverfahren geeignet.

Da durch das oben beschriebene Verfahren ein besonders gleichmäßiges und qualitativ hochwertiges Graphen hergestellt werden kann, ist auch ein Graphen hergestellt in dem beschriebenen Verfahren erfindungsgemäß.

Erfindungsgemäß ist weiters ein kupferbeschichtetes Metallblech, insbesondere Metallband, zur Verwendung in einem Verfahren nach einem der Ansprüche 1 bis 7, wobei das Metallblech einen Wärmeausdehnungskoeffizienten im Bereich von 20 - 400°C unter 20 [10^-6 m/(m x K)], insbesondere unter 15 [10^-6 m/(m x K)], vorzugsweise unter 12 [10^-6 m/(m x K)], aufweist. Durch den niedrigen Wärmeausdehnungskoeffizienten können Beschädigungen der Struktur des Graphens beim Abkühlen des Graphens auf dem Trägermaterial vermieden werden.

Durch das kupferbeschichtete Metallblech wird die kostengünstige Herstellung von qualitativ besonders hochwertigem Graphen ermöglicht.

Besonders geeignet zur Herstellung von Graphen ist ein kupferbeschichtetes Metallblech wobei das Metallblech aus einer Stahllegierung oder einer Aluminiumlegierung besteht.

Um eine möglichst gleichmäßige Struktur des Graphens auch bei der Abkühlung zu erhalten, ist besonders ein geeignet, wobei die Legierung die folgende Zusammensetzung (in Gew %) aufweist:

| | |
|---|---|
| 0,01 bis 0,20 | Kohlenstoff (C), |
| 30 bis 40 | Nickel (Ni) |
| 0,01 bis 0,60 | Mangan (Mn), |
| 0,01 bis 0,40 | Silizium (Si), |
| < 0,06 | Phosphor (P), |
| < 0,04 | Schwefel (S), |

optional enthaltend:

| | |
|---|---|
| 0 bis 0,25 | Chrom (Cr), |
| 0 bis 0,50 | Kobalt (Co) |
| 0 bis 0,20 | Aluminium (Al), |
| 0 bis 0,50 | Molybdän (Mo) |
| 0 bis 0,50 | Kupfer (Cu) |
| 0 bis 0,30 | Vanadium (V) |
| 0 bis 0,20 | Titan (Ti) |
| 0 bis 0,20 | Niob (Nb) |
| 0 bis 0,005 | Bor (B) |
| 0 bis 0,015 | Stickstoff (N) |
| 0 bis 0,01 | Kalzium (Ca) |

sowie als Rest Eisen (Fe) und herstellungsbedingt unvermeidbare Verunreinigungen.

Hierbei ist insbesondere der Stahlwerkstoff 1.3912 besonders geeignet, da er einerseits einen geringen Ausdehnungskoeffizienten aufweist, sodass beim Abkühlen des Graphens Beschädigungen in der Struktur vermieden werden können, und andererseits kann auf diesem Werkstoff Kupfer besonders gleichmäßig aufgebracht werden. Auch der Stahlwerkstoff 1.4412 kann verwendet werden.

Durch ein kupferbeschichtetes Metallblech, wobei die Kupferschicht eine 111-Ausrichtung aufweist, kann eine besonders hohe Qualität des Graphen erzielt werden.

Um die oftmalige Wiederverwendung des kupferbeschichteten Metallblechs als Trägermaterial zu ermöglichen, kann die Kupferschicht eine Dicke von 0,1 µm bis 100 µm aufweisen. Hierbei hat sich herausgestellt, dass der Schichtdickenbereich von 1 µm bis 75 µm sich besonders auszeichnen kann, da einerseits die Haftvermittlung bei vergleichsweise dünnen Schichtdicken verbessert werden kann und andererseits die Kratzfestigkeit und Abriebfestigkeit sichergestellt ist.

Da das zuvor beschriebene kupferbeschichtete Metallblech besonders geeignet ist zur Herstellung von Graphen nach dem eingangs beschriebenen Verfahren, insbesondere dem CVD-Verfahren, ist auch die Verwendung des kupferbeschichteten Metallblechs als Trägermaterial in einem solchen Verfahren erfindungsgemäß. Dadurch kann kostengünstig qualitativ hochwertiges Graphen hergestellt werden.

Die Erfindung ist ohne Einschränkung des allgemeinen erfinderischen Gedankens anhand der Zeichnung beispielhaft beschrieben:

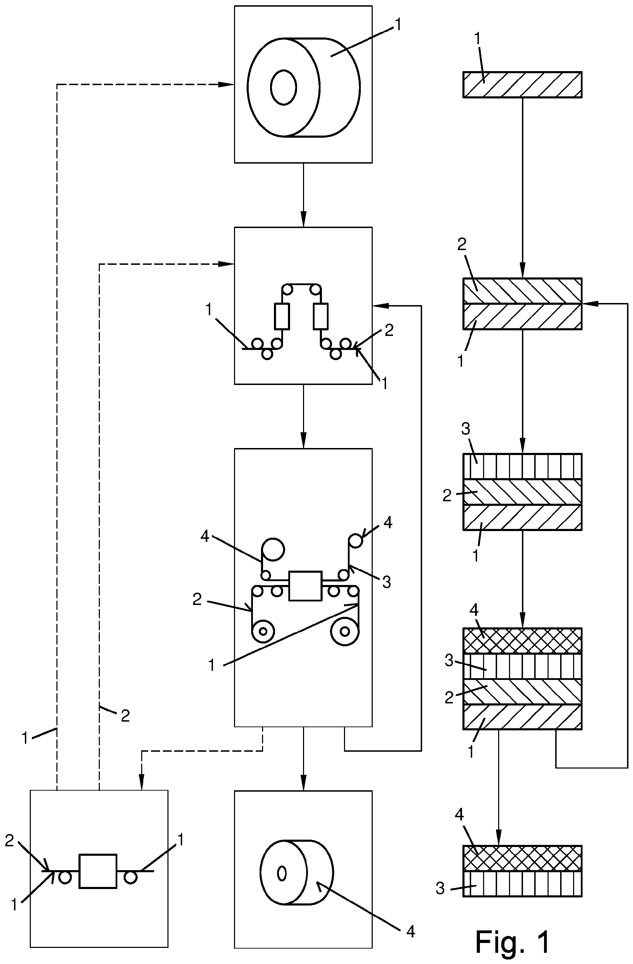

Fig. 1 zeigt den schematischen Ablauf eines beispielhaften Verfahrens.

In Fig.1 ist gezeigt, dass zunächst ein Metallblech, in der dargestellten Ausführungsform ein Metallband 1, mit Kupfer beschichtet wird. Das Metallband 1 ist in der dargestellten Ausführungsform aus dem Stahlwerkstoff 1.3912 hergestellt. Die Kupferbeschichtung 2 wird durch physikalische Gasphasenabscheidung (PVD-Verfahren) aufgebracht. In der dargestellten Ausführungsform weist die Kupferschicht 2 eine Schichtdicke von 0,1 µm bis 100 µm auf. Die Kupferschicht 2 weist zudem in der dargestellten Ausführungsform eine 111-Ausrichtung auf.

Auf dem kupferbeschichteten Metallband als Trägerschicht wird durch chemische Gasphasenabscheidung (CVD-Verfahren) Graphen 3 hergestellt, das sich auf der Kupferschicht 2 in hoher Qualität abscheidet. Nach dem Abkühlen des Graphens 3 wird das Graphen 3 zur Lagerung auf eine Lagerfolie 4 übertragen und durch Bubble-Transferprozess vom Trägermaterial gelöst. Das Trägermaterial kann anschließend wiederverwendet werden und es kann erneut Graphen 3 auf der Kupferbeschichtung 2 abgeschieden werden.

Wenn es nach oftmaliger Verwendung des Trägermaterials zu einer Abnutzung der Kupferschicht 2 gekommen ist, kann das Kupfer abgebeizt werden. Das Kupfer kann aus der Lösung wiedergewonnen werden und nach einer Reinigung erneut zur Beschichtung eines Metallbandes 1 verwendet werden. Das Metallband 1 kann nach dem Abbeizen ebenfalls gereinigt werden und anschließend erneut mit Kupfer beschichtet werden.

Dadurch kann ein ressourcenschonendes kostengünstiges Verfahren zur Herstellung von qualitativ hochwertigem Graphen bereitgestellt werden.

## Patentansprüche

1. Verfahren zur Herstellung von Graphen (3), wobei ein Trägermaterial bereitgestellt wird, wobei auf dem Trägermaterial Graphen (3) durch chemische Gasphasenabscheidung hergestellt wird, wobei das Graphen (3), insbesondere durch einen Bubble-Transferprozess, vom Trägermaterial abgelöst und zur Lagerung auf eine Lagerfolie (4) übertragen wird, **dadurch gekennzeichnet, dass** als Trägermaterial ein kupferbeschichtetes Metallblech bereitgestellt wird.

2. Verfahren nach Anspruch 1, wobei das bereitgestellte Metallblech (1) aus einer Legierung mit einem Wärmeausdehnungskoeffizienten im Temperaturbereich von 20 - 400°C unter 20 [10^-6 m/(m x K)], bevorzugt unter 15 [10^-6 m/(m x K)], besonders bevorzugt unter 12 [10^-6 m/(m x K)], besteht.

3. Verfahren nach einem der Ansprüche 1 oder 2, wobei das bereitgestellte Metallblech (1) aus einer Stahllegierung oder einer Aluminiumlegierung besteht.

4. Verfahren nach einem der Ansprüche 1 bis 3, wobei das bereitgestellte Metallblech (1) eine Legierung mit der folgenden Zusammensetzung enthält (in Gew%):
| | |
|---|---|
| 0,01 bis 0,20 | Kohlenstoff (C), |
| 30 bis 40 | Nickel (Ni), |
| 0,01 bis 0,60 | Mangan (Mn), |
| 0,01 bis 0,40 | Silizium (Si), |
| < 0,06 | Phosphor (P), |
| < 0,04 | Schwefel (S), |
optional enthaltend:
| | |
|---|---|
| 0 bis 0,25 | Chrom (Cr), |
| 0 bis 0,50 | Kobalt (Co), |
| 0 bis 0,20 | Aluminium (Al), |
| 0 bis 0,50 | Molybdän (Mo), |
| 0 bis 0,50 | Kupfer (Cu), |
| 0 bis 0,30 | Vanadium (V), |
| 0 bis 0,20 | Titan (Ti), |
| 0 bis 0,20 | Niob (Nb), |
| 0 bis 0,005 | Bor (B), |
| 0 bis 0,015 | Stickstoff (N), |
| 0 bis 0,01 | Kalzium (Ca), |
sowie als Rest Eisen (Fe) und herstellungsbedingt unvermeidbare Verunreinigungen, wobei das Metallblech (1) insbesondere aus dem Stahlwerkstoff 1.3912 oder dem Stahlwerkstoff 1.4112 besteht.

5. Verfahren nach einem der Ansprüche 1 bis 4, wobei das bereitgestellte Trägermaterial eine Kupferschicht (2) in 111-Ausrichtung aufweist.

6. Verfahren nach einem der Ansprüche 1 bis 5, wobei das Trägermaterial hergestellt wird, indem die Kupferschicht (2) auf dem Metallblech (1) durch Gasphasenabscheidung, insbesondere physikalische Gasphasenabscheidung, aufgebracht wird, insbesondere mit einer Geschwindigkeit von 10 bis 180 m / min.

7. Verfahren nach einem der Ansprüche 1 bis 6, wobei das Trägermaterial nach dem Ablösen des Graphens (3) wieder für die Herstellung von Graphen bereitgestellt wird.

8. Graphen (3) hergestellt in einem Verfahren nach einem der Ansprüche 1 bis 7.

9. Kupferbeschichtetes Metallblech, insbesondere Metallband, zur Verwendung in einem Verfahren nach einem der Ansprüche 1 bis 7, wobei das Metallblech (1) einen Wärmeausdehnungskoeffizienten im Temperaturbereich von 20 - 400°C unter 20 [10^-6 m/(m x K)], bevorzugt unter 15 [10^-6 m/(m x K)], besonders bevorzugt unter 12 [10^-6 m/(m x K)], aufweist.

10. Kupferbeschichtetes Metallblech nach Anspruch 9, wobei das Metallblech (1) aus einer Stahllegierung oder einer Aluminiumlegierung besteht.

11. Kupferbeschichtetes Metallblech nach Anspruch 10, wobei die Legierung die folgende Zusammensetzung (in Gew %) aufweist:
| | |
|---|---|
| 0,01 bis 0,20 | Kohlenstoff (C), |
| 30 bis 40 | Nickel (Ni), |
| 0,01 bis 0,60 | Mangan (Mn), |
| 0,01 bis 0,40 | Silizium (Si), |
| < 0,06 | Phosphor (P), |
| < 0,04 | Schwefel (S), |
optional enthaltend:
| | |
|---|---|
| 0 bis 0,25 | Chrom (Cr), |
| 0 bis 0,50 | Kobalt (Co), |
| 0 bis 0,20 | Aluminium (Al), |
| 0 bis 0,50 | Molybdän (Mo), |
| 0 bis 0,50 | Kupfer (Cu), |
| 0 bis 0,30 | Vanadium (V), |
| 0 bis 0,20 | Titan (Ti), |
| 0 bis 0,20 | Niob (Nb), |
| 0 bis 0,005 | Bor (B), |
| 0 bis 0,015 | Stickstoff (N), |
| 0 bis 0,01 | Kalzium (Ca), |
sowie als Rest Eisen (Fe) und herstellungsbedingt unvermeidbare Verunreinigungen, wobei das Metallblech (1) insbesondere aus dem Stahlwerkstoff 1.3912 oder dem Stahlwerkstoff 1.4112 besteht.

12. Kupferbeschichtetes Metallblech nach einem der Ansprüche 9 bis 11, wobei die Kupferschicht (2) eine 111-Ausrichtung aufweist und/oder wobei die Kupferschicht (2) eine Dicke von 0,1 µm bis 100 µm, insbesondere von 1 µm bis 75 µm, aufweist.

13. Kupferbeschichtetes Metallblech nach einem der Ansprüche 9 bis 12, wobei auf der Kupferschicht (2) Graphen (3) angeordnet ist.

14. Verwendung eines kupferbeschichteten Metallblechs als Trägermaterial zur Abscheidung von Graphen (3) durch chemische Gasphasenabscheidung, insbesondere zur Verwendung in einem Verfahren nach einem der Ansprüche 1 bis 7.

15. Verwendung nach Anspruch 14, wobei das kupferbeschichtete Metallblech nach einem der Ansprüche 9 bis 13 ausgebildet ist.
